Europäisches Patentamt

European Patent Office

Office européen des brevets

(11) Publication number: **0 276 539 B1**

(12) **EUROPEAN PATENT SPECIFICATION**

(45) Date of publication of patent specification: **12.08.92**    (51) Int. Cl.5: **H05K  13/00**

(21) Application number: **87308505.4**

(22) Date of filing: **25.09.87**

(54) **Carrier tape.**

(30) Priority: **25.09.86 US 913131**
**29.01.87 US 8293**
**04.05.87 US 46259**

(43) Date of publication of application:
**03.08.88 Bulletin  88/31**

(45) Publication of the grant of the patent:
**12.08.92 Bulletin  92/33**

(84) Designated Contracting States:
**AT BE CH DE FR GB IT LI NL SE**

(56) References cited:
**EP-A- 0 066 339**    **DE-A- 1 764 913**
**FR-A- 2 503 673**    **GB-A- 2 103 561**
**US-A- 3 465 874**    **US-A- 3 893 212**

(73) Proprietor: **ILLINOIS TOOL WORKS INC.**
**8501 West Higgins Road**
**Chicago, Illinois 60631-2887(US)**

(72) Inventor: **Boeckmann, Hugo**
**1318 South Walnut Street**
**Arlington Heights, Illinois 60005(US)**
Inventor: **Ausnit, Steven**
**124 East 64th Street**
**New York, New York 10021(US)**
Inventor: **Nocek, Robert S.**
**377 Glenbrook Road**
**Stamford, Connecticut 06906(US)**
Inventor: **Huff, Glen E.**
**713 Shady Lane**
**Bedford, Texas 76021(US)**
Inventor: **Tilman, Paul A.**
**43 Carolina Drive**
**New City, New York 10956(US)**
Inventor: **Borts, Herbert A.**
**124 Western Highway**
**West Nyack, New York 10994(US)**
Inventor: **Machacek, Zdenek**
**2 Charles Street**
**Nanuet, New York 10954(US)**
Inventor: **Schnittger, Ernest**
**88 Spook Rock Road**
**Suffern, New York 10901(US)**
Inventor: **Schulte, Richard D.**
**7031 Wright Terrace**
**Niles, Illinois 60648(US)**
Inventor: **Scott, Richmond**
**1 Green Meadow Place**
**Pleasantville, New York 10570(US)**

(74) Representative: **Blatchford, William Michael et al**
**Withers & Rogers 4 Dyer's Buildings Holborn**
**London EC1N 2JT(GB)**

EP 0 276 539 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to carrier tapes and in particular to a reuseable carrier tape for transporting electronic components, pharmaceuticals, and the like during production and assembly operations.

In the assembly of various types of electronic devices, such as, for example, computers and related products, it is common to transport miniature and subminiature components from one station to another by means of a carrier tape. At the assembly stations automatic equipment functions to remove the components from the carrier tape and mount the components to a circuit board or the like as may be required. The carrier tape (or transfer tape as it is sometimes referred to) may also function to bring different components to an assembly station in proper order for sequential assembly. Such tapes are often formed from an elongated base strip of plastic or paper usually covered by a cover strip. The base strip is often provided with cavities which are contoured to hold the components in a particular orientation. The cover strip is usually held in place by an adhesive or heat bond which must be broken at the assembly station to permit the component to be removed after the cover is stripped back. Typical examples of prior art carrier tapes are disclosed in U.S. Patent Nos. 3,465,874; 3,650,430; 3,894,896; 3,920,410 and 4,298,120.

A problem often associated with such prior carrier tapes is that the cover strip must be securely affixed to the base strip and the adhesive bond must subsequently be broken without damaging the cover sheet or base carrier tape or sticking to the component since this could interfere with the transport and assembly mechanism. An essential requirement of the cover strip is that it must separate from the base strip at a known and predictable rate without disturbing the components. This is known as consistant peel strength. In the past adhesives and heat sealing were the principal means for sealing the base and cover strips which often rendered these non-reuseable. In many ultra-clean applications the use of such adhesives and heat bonds is undesirable out of concern that residue may contaminate the component or mounting board. In addition, heat seal bonds are generally non-uniform due to the occurrence of tiny hills and valleys on the strip during the heating operation. This may result in the cover strip stripping away prematurely, (which could result in lost components) or remaining in place overly long. In either event the automatic operation would be interfered with.

Also, with many electronic components it is desirable to load the carrier tape with static-dissipative or conductive materials to prevent or dissipate any build-up of electrostatic charge. These materials often tend to interfere with the bonding characteristics of the adhesives used.

To fuction properly, a carrier tape must securely convey its cargo as required and then, at the proper location, be capable of being quickly and positively opened so that the component may be easily removed for assembly purposes. The tape should afford a degree of protection for the sensitive components to be conveyed therein with respect to contamination, electro-static discharge, temperature change and mechanical shock. In addition, the seal or bond between the tape components must be releasable to a known and consistent value at the unloading point to insure that only the required length of base tape will be exposed.

Prior art tapes utilizing heat activated adhesives or heat bonding techniques present a risk of adhesive residue contamination of the component. In addition, such tapes cannot be readily opened and reclosed for quality testing or the like and present difficulties in aligning the cover and base strips. Further, heat bonding requires the use of relatively high temperatures which may be harmful to the components to be carried. In addition, the use of static-dissipative or conductive additives to prevent or dissipate the build-up of electrostatic charges tend to interfere with the bonding characteristics of the adhesives used.

In U.S. Patent Nos. 3,465,874 and 3,650,430 an attempt is made to solve these problems by providing spaced snaps or push buttons on one of the strips to engage spaced holes in the other of the strips. This arrangement, obviously requires somewhat precise alignment of the snaps and openings in order to operate. Further, the strips are not uniformly secured to each other but rather continuously oscillate between secured and non-secured conditions.

In view of the above, it is the principal object of the present invention to provide an improved carrier tape construction which avoids the use of adhesive and chemical bonding, in which the base and cover strips are uniformly and consistently secured to each other and which requires a uniform force for separation so that they may readily be separated in a precise manner.

An advantage of such a carrier tape is that it may readily be used on existing equipment with little or no modification and that it is competitive pricewise with existing products.

The cover and base strips of such tapes automatically align with each other during assembly and, if necessary, may be opened and reclosed.

A still further object is to provide a simple and reliable mechanism for properly securing the base and cover strips of such a carrier tape to each other.

Still another object is to provide a simple and reliable mechanism for properly separating the base and Cover strips of such a carrier tape from one another.

The above and other beneficial objects and advantages are attained in accordance with the present invention by providing a carrier tape comprising:

an elongated base strip;

an elongate cover strip formed of a resilient plastic material substantially coextensive in length with the base strip, the cover strip having a top surface and opposed sidewalls extending downwardly from the top surface and spaced apart from each other a distance substantially equal to the width of the base strip and cooperating to secure the cover strip to the base strip, and a hump extending longitudinally, parallel to the sidewalls, projecting upwardly from the top surface, whereby the hump is depressed the sidewalls move outwardly, away from each other to release the cover strip from the base strip. One of the strips, usually the base strip, may be provided with longitudinally spaced cavities for the components as well as longitudinally spaced sprocket drive holes for advancing the tape through the assembly mechanism. A longitudinally extending continuous profile is integrally formed on at least one of the strips to cooperate with surfaces of the other strip to secure the two in a looking engagement. The surfaces of the other strip may comprise an integral profile complementary to that of the one strip.

In another aspect the invention provides a device for applying a carrier tape cover strip to a base strip, the cover strip being of the type having a top surface with a longitudinally extending hump projecting upwardly therefrom and sidewalls extending parallel to the hump extending downwardly from the top surface; the device comprising:

a guide for receiving the base strip; and

a feed channel member overlying the guide for receiving the cover strip and feeding the cover strip into a position over the base strip, the feed channel member including an inner face contoured to receive the cover strip including a ridge to receive the hump and means for exerting a downward force on the hump as the cover sheet passes through the channel.

In yet another aspect the invention provides a device for separating a carrier tape cover strip from its base strip, the cover strip being of the type having a top surface with a longitudinally extending hump projecting upwardly therefrom and side walls extending parallel to the hump extending downwardly from the top surface and about the base strip, the device comprising: means for advancing the carrier tape, means for applying a downward force on the hump as the tape advances whereby to separate the cover strip from the base strip and means for directing the cover strip out of the path of movement of the base strip.

The invention also provides a method of applying a carrier tape cover strip to a base strip, the cover strip being of the type having a top surface with a longitudinally extending hump projecting upwardly therefrom and sidewalls extending parallel to the hump extending downwardly from the top surface; the method including the step of:

exerting a downward force on the hump as the cover strip is being fed over the base strip whereby to cause the sidewalls to move outwardly to clear the base strip; and thereafter,

removing the downward force from the hump thereby to cause the sidewalls to move inwardly to engage the base strip.

Embodiments of the invention are described hereinafter, by way of example only, with reference to the accompanying drawings of which:-

Figure 1 is a perspective view of a cover sheet of a first embodiment of a carrier tape in accordance with the present invention;

Figure 2 is a perspective view of the base sheet of the carrier tape of Figure 1;

Figure 3 is a perspective view of a carrier tape formed of cover and base sheets as shown in Figures 1 and 2 (but with slightly modified profiles);

Figures 4 and 5 are perspective views depicting the opened and closed conditions of a second embodiment of a carrier tape wherein the cover and base sheets are formed in one piece;

Figure 6 is a perspective view of the base strip of a third embodiment of the carrier tape of the present invention;

Figures 7 and 8 are perspective views of the cover strip of the carrier tape of the third embodiment shown before and after securement to the base strip;

Figures 9 and 9A are side elevational sectional views of the third embodiment of the carrier tape of the present invention and a modification thereof; and,

Figure 10 is a side elevational sectional view of a fourth embodiment of the carrier tape of the present invention.

Figure 11 is a fragmentary, exploded, perspective view of a carrier tape in accordance with another aspect of the present invention;

Figure 12 is an exploded, side elevational sectional view of the carrier tape of Figure 11;

Figure 13 is a side elevational sectional view of the carrier tape of Figure 11 as subjected to a force to enable assembly or disassembly of the tape;

Figure 14 is a side elevational section view of the carrier tape of Figure 11 as assembled;

Figure 15 is a diagrammatic view of a station for joining the top and bottom strips of the present carrier tape;

Figure 16 is an enlarged fragmentary sectional view taken along reference lines VI-VI of Figure 15;

Figure 17 is a diagrammatic view of a station for separating the top and bottom strips of the present carrier tape;

Figure 18 is a simplified front view of the stripping mechanism of the station of Figure 17; and,

Figure 19 is a simplified side view of the stripping mechanism.

Figure 20 is a perspective view of a sixth embodiment of a carrier tape in accordance with the present invention;

Figure 21 is an elevational sectional view of the carrier tape of Figure 20;

Figure 22 is an elevational sectional view of a seventh embodiment of the carrier tape of the present invention; and,

Figure 23 is an elevational sectional view of an eighth embodiment of the carrier tape of the present invention.

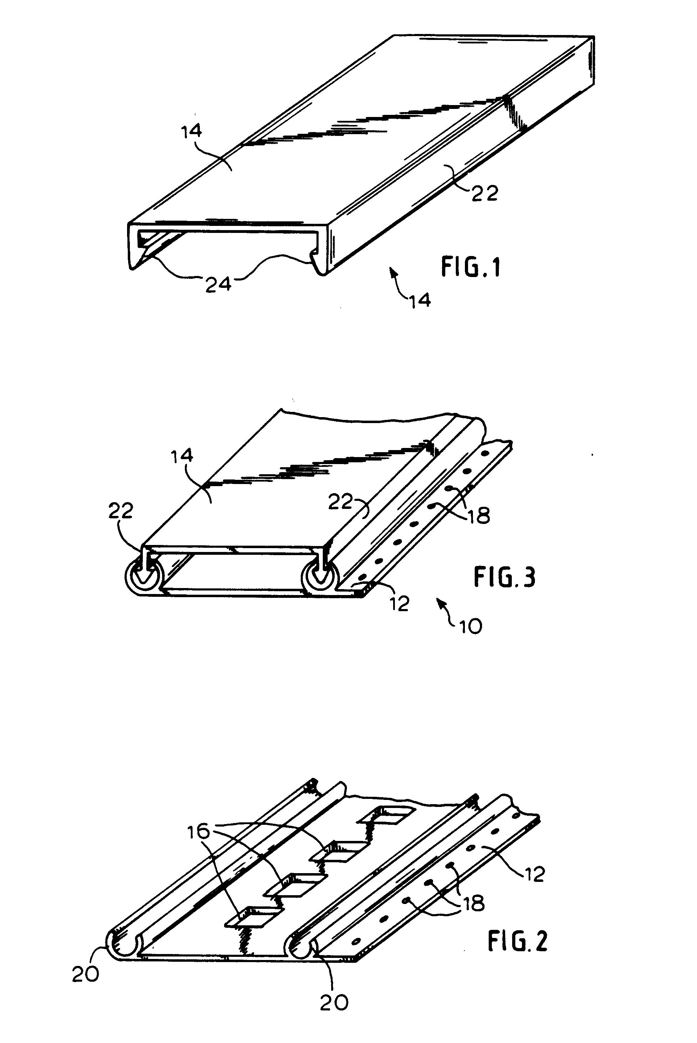

Reference is now made to the drawings and to Figures 1-3 in particular wherein a first embodiment of the carrier tape 10 of the present invention is depicted comprising an elongate base strip 12 and generally coextensive cover strip 14. The carrier tape 10 is preferably formed of a suitable plastic film material such as polyvinyl chloride, polypropylene or a plastic glycol such as polyethylene terephthalate glycol which may readily be extruded and vacuum or pressure formed to the desired shape. The tape should be sufficiently flexible to permit it to be spooled. The base 12 is formed with a plurality of cavities 16 which define individual pockets for the components to be transported. In this regard the cavities may be contoured, as required, to maintain the components in a particular orientation should such orientation be necessary. The base strip 12 is further provided with longitudinally spaced sprocket holes 18 which are designed to be engaged by an appropriate sprocket drive on the assembly equipment which serves to propel the tape. Although the sprocket holes are usually in the base strip, if required they may be positioned in the cover strip or extending through both the base strip and the cover strip.

In accordance with the present invention, a profile shape 20 is extruded along each edge of the base strip 12. The profile is formed, for example, in the female shape described in U.S. Patent No. Re 28,969 and is designed to cooperate with complementary male profiles on the cover sheet 14 in a manner such as described in U.S. Patent Nos. 3,893,212; 3,982,306 and 3,999,258. Thus, the cover sheet 14 is provided with downwardly extending edges 22 which terminate in male profiles 24. The male profiles may be of the assymetric arrowhead shaped configuration described in the aforementioned patent Re 28,969 or the profiles may be of a simplified shape as shown in Figure 1. The shape chosen for the profiles, to a large extent will depend upon the force desired or required for separating the base sheet from the cover sheet. This, in turn, will depend upon the assembly equipment with which the tape is to be used.

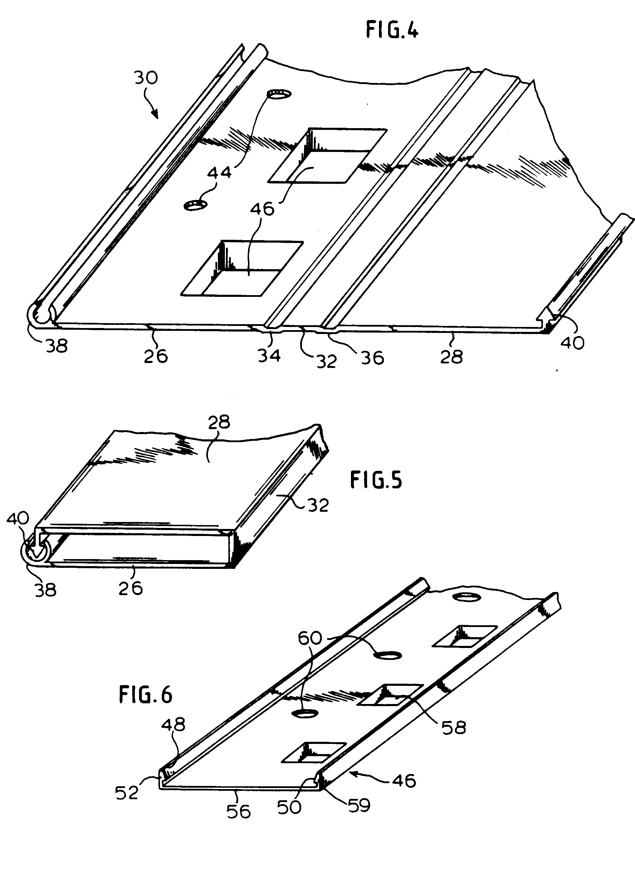

In Figures 4 and 5 a second embodiment of the present invention is shown. In this embodiment the base strip 26 and the cover strip 28 of the carrier tape 30 are formed in one piece separated by a side section 32 defined between a pair of longitudinally extending crease lines 34, 36. A female profile 38 extends upwardly from one longitudinal edge and a mating male profile 40 extends upwardly from the opposite longitudinal edge. Component cavities 42 and sprocket holes 44 are formed in the base strip 26 as previously described. When the carrier tape is in the closed position (shown in Figure 5) the male profile is positioned to engage the female profile to position and secure the cover sheet firmly over the base sheet thereby securing any components within the component cavities. The configuration of the male and female profiles may be shaped as previously described.

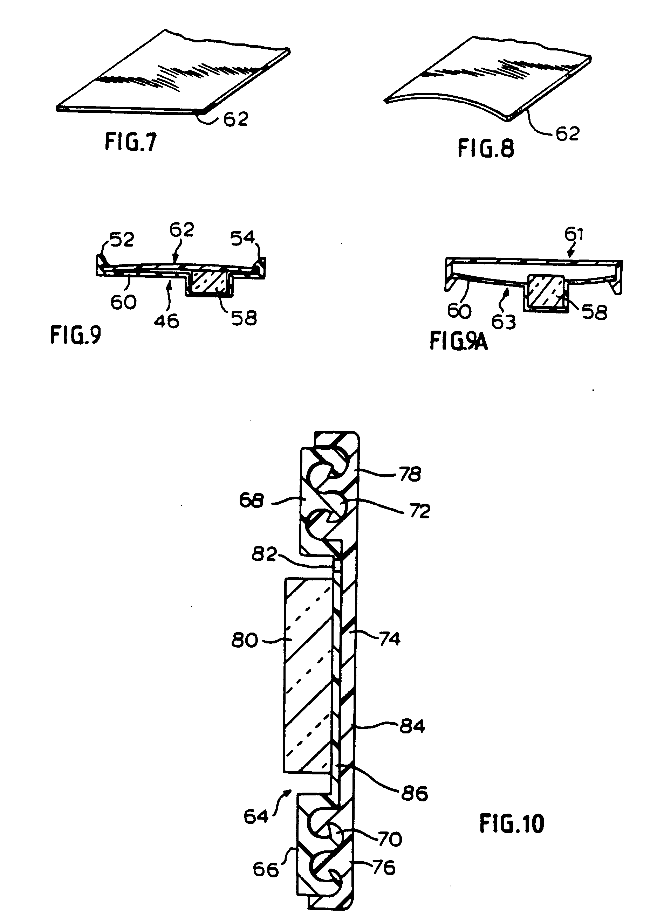

In Figures 6-9 a third embodiment of the present invention is depicted. In this embodiment the base strip 46 is formed with profiles 48, 50 at its opposed longitudinal edges. The edges are formed with inwardly turned lips 52, 54 which are directed toward each other. The profiles are configured so that the lips are spaced above the base 56 of the strip 46 as shown in Figures 6 and 9. The base strip 46 includes a series of longitudinally spaced component cavities 58 and sprocket holes 60. In this embodiment the cover strip 62 comprises an elongate strip of plastic material designed to snap fit into position. That is, the cover sheet which tends to be naturally flat (as shown in Figure 7) is curved (as shown in Figure 8) to permit it to pass between the profiles of the base sheet and to snap into position captured beneath the lips 52, 54 as shown in Figure 9. In this position the cover sheet tends to press against any components seated within the cavities 58 to secure the components against any extraneous movement. A modification of this embodiment is shown in Figure 9A. In this embodiment the base sheet 63 is formed with product cavities 58 and sprocket holes 60. The cover 61 may be as shown in Figure 1.

In the embodiment of Figure 10 the base strip 64 is formed with outer margin portions 66, 68 which carry profiles 70, 72. The cover strip 74 is also formed with outer margin portions 76, 78 which carry profiles complementary to those on the base strip. Component cavities and sprocket holes are formed in the base strips as previously described. This embodiment has the advantage of enabling the cover strip to fit tightly against the base strip since the main portion 84 of the cover strip can sit firmly atop the main portion 86 of the base strip.

In each of the above embodiments the base strip and cover strip may readily be extruded of plastic material with the profiles formed integrally. It is important to note that the profiles are continuous over the length of the strip (or strips) so that the strips may be engaged without any longitudinal alignment and without regard to the relative longitudinal positions of the base strip and cover strip. The plastic material may be formulated so as to give the tape desired physical properties such anti-magnetic, antistatic, infra-red impervious or the like. Although the component cavities are shown in the base strip in each embodiment it should be appreciated that all or a portion of the component cavities may be formed in the cover strip if required by a particular application.

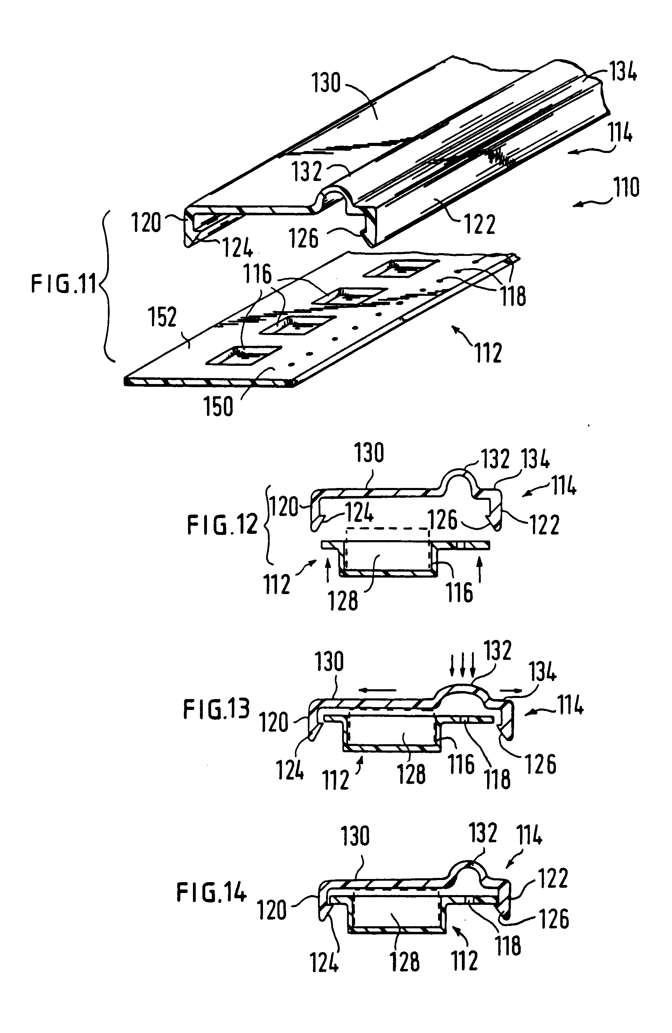

Reference is now made to Figures 11-14 wherein a carrier tape 110 is depicted as comprising an elongated base strip and generally coextensive cover strip 114. The carrier tape 110 is preferably formed of a suitable plastic film material such as carbon loaded polyvinyl chloride, polypropylene or a glycol based polyester such as polyethylene terephthalate (PETG) which may readily be extruded and vacuum or pressure formed to the desired shape. The carrier tape resin may be formulated with appropriate additives to render the tape components anti-static or static dissipative as may be required. The tape should be sufficiently flexible to permit it to be spooled.

The base 112 is formed with a plurality of cavities 116 which define individual pockets of the components to be conveyed therein. In this regard the cavities may be contoured, as required, to maintain the components in a particular orientation, should such orientation be necessary. A series of aligned sprocket holes 118 is provided extending through the base strip 112, adjacent to and outward of the cavities 116.

The cover strip 114 is coextensive in length with the base strip 112. The cover strip 114 is provided, at each side, with downwardly directed sidewalls 120, 122 each of which terminates in an inwardly directed profile barb 124, 126. The sidewalls are spaced apart from each other a distance substantially equal to the width of the base strip. The height of the sidewalls 120, 122 is such that when the cover strip 114 is engaged over the base strip the major portion of the top face 130 of the cover strip will cover a component 128 within cavity 116 while the profiles 124 and 126 engage the edge of the undersurface of the base strip, as shown in Figure 14.

In accordance with the present invention, the top tape 114 is further provided with a longitudinally extending upwardly projecting hump 132 along its entire length. The hump 132 is positioned to align over the line of sprocket holes 118 thereby providing clearance for engaging the protruding teeth of the sprocket drive wheel of the assembly equipment with which the tape is to be used. The hump 132 also provides a "living hinge" for the major 130 and minor 134 portions of the top face of the cover strip defined on opposite sides of the hump. Thus, when a downward force is exerted on the hump, both the major and minor face portions along with their attached sidewalls 120, 122 will move laterally outwardly. The extent of outward movement of the faces, in turn, is determined by the downward displacement of the hump. Accordingly, by making the hump high enough and by exerting a sufficient downward force, the profile barbs 124, 126 may be shifted clear of the edges of the base strip thereby releasing the cover strip from the base strip, as shown in Figure 103. As shown in Figure 104, the hump, when relaxed, tends to bias the sidewalls 120, 122 toward each other thereby providing a positive connection between the cover strip and base strip when assembled. It should be appreciated that the cover strip automatically aligns over the base strip by virtue of the sidewalls 120, 122 engaging the side edges of the base. In addition, the tape may be opened as may be required for sampling or other purposes and then readily reclosed.

Tape Joining Device

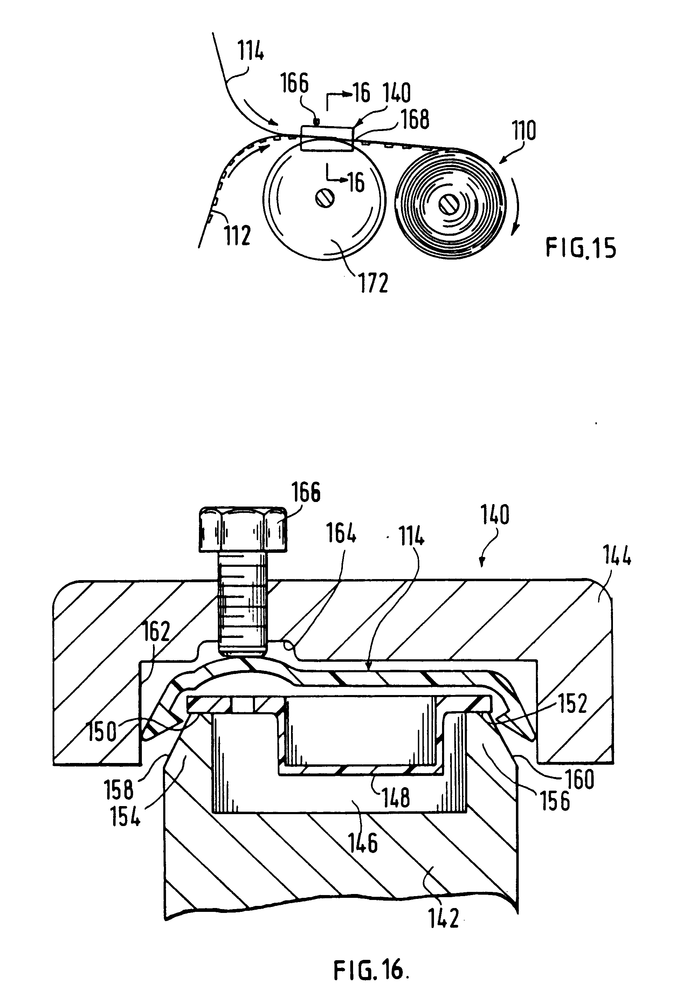

An apparatus for joining the bottom and top strips 112 and 114 of the carrier tape 110 is disclosed in Figures 15 and 16. As shown, a bottom strip 112, the cavities of which are loaded with components is brought horizontally to the joining station 140. A top strip 114 is also brought to the loading station where it is applied to the bottom strip. The assembled carrier tape 110 is then drawn off and spooled for subsequent shipment and use.

The details of the joining station 140 are shown in Figure 16. As shown, the joining station comprises a guide 142, which may be in the shape of a wheel, and a contoured feed channel plate 144 positioned over the guide. The top edge of guide 142 is provided with a central groove 146, the depth of which is sufficient to provide clearance for the bottom 148 of the component cavities 116 while the bottom edges 150, 152 of the bottom strip rest on the edges 154, 156 that define groove 146 of the wheel 142. The outside surfaces 158, 160 of the guide adjacent the bottom strip edge are tapered inwardly to define camming surfaces for the sidewalls 120, 122 of the top strip as will be described.

The top strip is brought to the joining station where it tracks the contoured inner face 162 of the feed channel plate 144. The inner face 162 of plate 144 is provided with a ridge 164 to receive the hump 132 of the top strip. The height of the ridge gradually decreases towards the exit end of the joining station so as to gradually apply pressure to the top strip hump and thereby cause the sidewalls 120, 122 of the top tape to move laterally outwardly as shown in Figure 13. An adjustable pressure screw 166 may be provided to insure that sufficient pressure is applied to the top strip hump to obtain the necessary lateral movement of the top strip sidewalls to clear the side edges of the base strip. To this end, the sidewalls 120, 122 are spread out sufficiently so that the profile barbs 124, 126 ride along the angled cam surfaces 158, 160 as shown.

At the exit 168 of the joining station 140 pressure is removed from hump 132 of the top strip. At the same time, the angled cam surfaces 158, 160 are removed from supporting the sidewalls 120, 122 outwardly. As a result, the resiliency of the sidewalls 120, 122 coupled with the hinge action of the hump cause the sidewalls to snap inwardly towards each other thereby securely engaging the edges of the bottom strip as shown in Figure 14.

Tape Separating Device

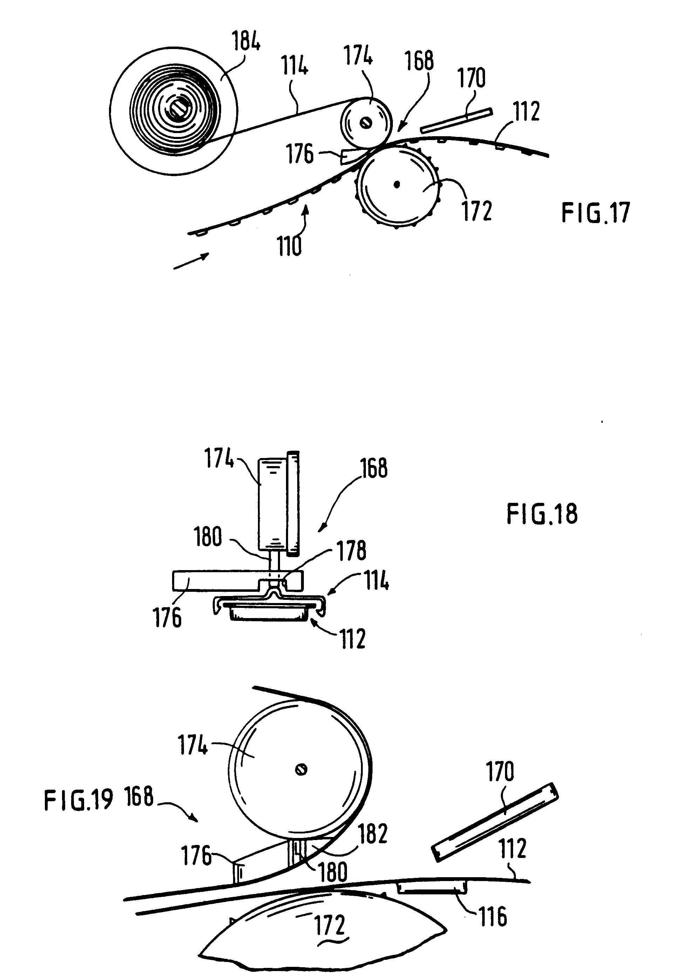

A device for stripping the cover 114 from the carrier tape 110 is depicted in Figures 17-19. It should be appreciated that the cover stripping mechanism 168 is designed to be used with existing "pick and place" carrier tape utilizing machines 170 without disturbing their normal functions of picking a component from the carrier tape 110 and placing it in position for surface mounting or some other operation.

In this regard, the cover stripping device 168 comprises a toothed drive wheel 172 which engages the carrier tape sprocket holes 118 in a conventional manner to advance the tape 110 to the pick and place mechanism 170. As previously mentioned, the teeth of wheel 172 have a clearance area above each sprocket hole 118 of the tape by virtue of the hump 132 being positioned above the sprocket holes. At the mechanism 170, the carrier tape must be open and the cover stripped away so that the component contained therein can be removed without interference. To this end, the cover stripping mechanism 168 is positioned slightly upstream of the pick up device 170 as shown in Figure 17. The cover stripping mechanism 168 comprises a grooved wheel 174 and a stripping plate 176 mounted to the tape transport mechanism frame. The stripping plate 176 is provided with a groove 178 dimensioned to capture the hump 132 of the cover strip 114 of tape 110. A threaded or adjustable pressure rod 180 extends through the groove 178 to exert pressure on the top of the hump 132 thereby causing the sidewalls 120, 122 of the tape to flex outwardly to laterally clear the edge of the bottom strip (as shown in Figure 13). By raising or lowering the screw 180, the pressure exerted on the hump may be varied as required. The leading edge 182 of stripping plate 176 is tapered to lead the now separated cover strip 114 over the groove wheel to a conventional take up spooler 184. At the same time, the now exposed cavity 116 of the base strip is in position for the pick and place mechanism 170 to remove the component contained within the cavity. It should be noted that the angle of the leading edge 182 of the stripping plate is important in order to guide the tape cover strip up and away from the base strip so as not to interfere with the pick and place mechanism 170.

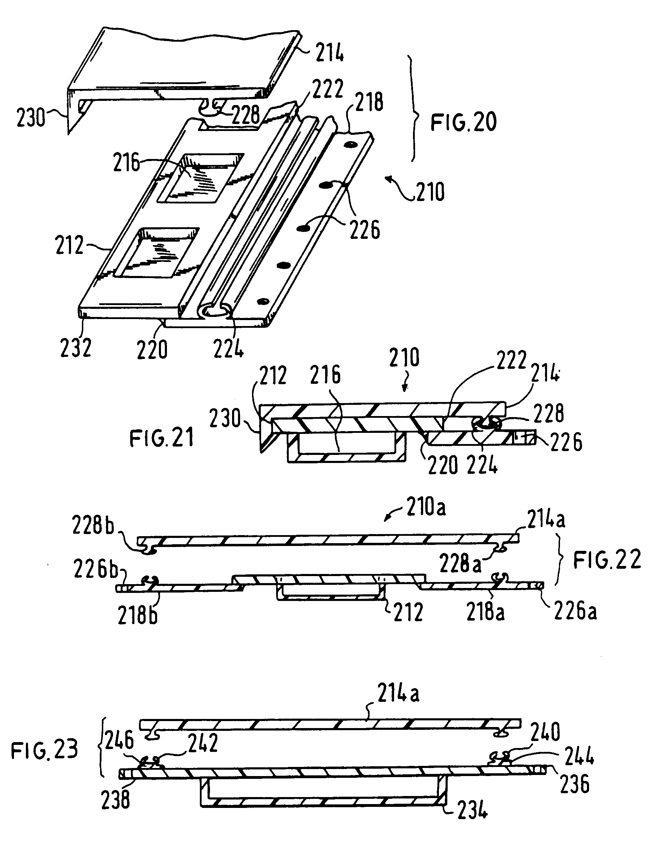

Reference is now made to Figures 20 and 21 in particular wherein a further carrier tape 210 in accordance with the present invention is depicted as comprising an elongated base strip 212 and a generally coextensive cover strip 214. The carrier tape 210 is preferably formed of a suitable plastic film material such as a carbon loaded polyvinyl chloride, polypropylene or a glycol based polyester such as polyethylene terephthalate (PETG) which may readily be extruded and vacuum or pressure formed to the desired shape. The tape should be sufficiently flexible to permit it to be spooled. The base 212 is formed with a plurality of cavities 216 which define individual pockets for the components to be transported. In this regard the cavities may be contoured, as required, to maintain the components in a particular orientation should such orientation be necessary.

The carrier tape 210 further includes a profile strip 218 which is bonded along a side margin 220 to a side 222 of the base strip 212. The profile strip may be formed of the same material as the base and/or cover strip or, if advantageous to do so, may be formed of a different material. The profile strip 18 may be adhesively bonded, heat sealed, or otherwise secured to the base strip along a continuous elongated bond line.

The profile strip 218 is extruded with an integral, continuous elongate profile shape 224. The profile may, for example, be in the shape of the female profile described in U.S. Patent Re 28,969. A line of longitudinally spaced sprocket holes 226 is provided on the profile strip outboard of the profile 224. That is, the profile 224 is interposed between margin 220 and the sprocket holes. The sprocket holes 226 are of a size and spaced so as to permit the carrier tape to be advanced by a sprocket drive of the associated equipment with which the tape is to be used.

The cover strip 214 is provided along one side with a male profile 228 designed to cooperate with the female profile 224 to form a continuous mechanical interlock as discussed in the aforementioned patent Re 28,969. A second profile, in the form of a hook 230 is provided on the opposite side of cover strip 214. As shown in Figure 21, the hook 230 clamps under the side 232 of base member 212 to cooperate with the female and male profiles 224, 228 in securing the cover strip 214 to base strip 212.

In the embodiment of Figure 22, the base strip 212 is provided with profile strips 218a and 218b which are each bonded to the base strip along the left and right sides. As in the previously described embodiment, the profile strips 218a and 218b are bonded to the base strip along continuous side margins. By providing sprocket holes 226a and 226b on both profile strips 218a and 218b the assembled carrier tape 210a may be driven from either the left or right side. The cover strip 214a of this embodiment is provided with male profiles 228a and 228b along both sides thereof for continuous engagement with the female profiles 226a and 226b of profile strip 218a and 218b, respectively.

In the embodiment of Figure 23, the base strip 234 is provided with two parallel lines of sprocket holes 236 and 238 along both sides. The profile strips 240, 242 are each provided with bottom margins 244, 246, respectively, which are continuously bonded to the top of the base strip positioned on opposite sides of the component cavities inboard of the sprocket holes. The cover strip 210a for this embodiment is the same, in construction, as that for the embodiment of Figure 22. It should be realized, however, that by omitting one of the profile strips the cover strip of the Figure 20 embodiment could be used.

It should be appreciated that in the embodiments of the present invention depicted in Figures 20-22 the base strip may be formed without regard to the drive arrangement of the mechanism to be used with the carrier tape since the sprocket holes for the drive assembly are contained in the separate profile tape. Similarly, the profile strips may be formed without regard to the components to be conveyed since the component cavities are in separate base strips. In this manner, each of the carrier tape parts may be manufactured in the most efficient manner without adversely affecting any other part.

Thus, in accordance with the above, the aforementioned objectives are effectively attained.

## Claims

1. A carrier tape comprising:
   an elongated base strip (112);
   an elongate cover strip (114) formed of a resilient plastic material substantially coextensive in length with the base strip, the cover strip having a top surface (130) and opposed sidewalls (120, 122) extending downwardly from the top surface and spaced apart from each other a distance substantially equal to the width of the base strip and cooperating to secure the cover strip to the base strip, and a hump (132) extending longitudinally, parallel to the sidewalls, projecting upwardly from the top surface, whereby the hump is depressed the sidewalls move outwardly, away from each other to release the cover strip from the base strip.

2. A carrier tape according to claim 1 wherein each sidewall terminates in an inwardly directed barb (124, 126) projecting beneath the base strip, the barbs extending a distance such that when the hump is depressed the barbs move outwardly to clear the base strip.

3. A carrier tape according to claim 1 wherein the base strip or the cover strip includes a plurality of longitudinally spaced, downwardly extending component cavities (116) therein.

4. A carrier tape according to claim 1 wherein the base strip includes a plurality of longitudinally spaced sprocket holes (118) extending therein.

5. A carrier tape according to claim 4 wherein the sprocket holes (118) are aligned with the cover strip hump.

6. A carrier tape according to claim 1 wherein the base includes a plurality of longitudinally spaced sprocket holes (118) extending therein adjacent the cavities (116).

7. A carrier tape according to claim 6 wherein the sprocket holes (118) are aligned with the cover strip hump.

8. A device for applying a carrier tape cover strip (114) to a base strip (112), the cover strip being of the type having a top surface (130) with a longitudinally extending hump (132) projecting upwardly therefrom and sidewalls (120, 122) extending parallel to the hump extending downwardly from the top surface; the device comprising:

a guide (142) for receiving the base strip; and

a feed channel member (144) overlying the guide for receiving the cover strip and feeding the cover strip into a position over the base strip, the feed channel member including an inner face (162) contoured to receive the cover strip including a ridge (164) to receive the hump and means (166) for exerting a downward force on the hump as the cover sheet passes through the channel.

9. A device according to claim 8 wherein the ridge (164) tapers downwardly in the direction of travel of the cover strip whereby to exert the downward force on the cover strip.

10. A device according to claim 8 wherein the force exerting means includes a rod extending through the ridge (164) whereby the downward force exerted on the cover strip can be varied by adjusting the extent of the screw.

11. A device according to claim 9 wherein the force exerting means includes a screw (166) extending through the ridge (164) whereby the downward force exerted on the cover strip can be varied by adjusting the extent of the screw.

12. A device according to claim 8 or claim 9 wherein the carrier tape base strip includes a plurality of longitudinally spaced component cavities (116) and the guide includes a grooved central portion (146) to receive the cavities.

13. A device according to any one of claims 8, 9 and 10 wherein the guide includes a top face for supporting the base strip and the guide further includes a pair of opposed sidewalls (154, 156) spaced outwardly of the top face, each of the sidewalls including a top section (158, 160) tapered upwardly toward the other sidewall.

14. A device according to claim 9 wherein the guide includes a top face for supporting the base strip and the guide further includes a pair of opposed sidewalls spaced outwardly of the top face, each of said sidewalls including a top section tapered upwardly toward the other sidewall.

15. A device for separating a carrier tape cover strip (114) from its base strip (112), the cover strip being of the type having a top surface (130) with a longitudinally extending hump (132) projecting upwardly therefrom and side walls (120, 122) extending parallel to the hump extending downwardly from the top surface and about the base strip, the device comprising: means (172) for advancing the carrier tape, means (180) for applying a downward force on the hump as the tape advances whereby to separate the cover strip from the base strip and means for directing the cover strip out of the path of movement of the base strip.

16. A device according to claim 15 wherein the directing means includes a plate (176) having a groove (175) to capture the hump (132) and a rod (180) extending through the groove to engage and apply a force to the hump.

17. A device according to claim 16 further including means for advancing the tape forwardly and wherein the plate includes a forward camming edge directing the cover strip rearwardly away from the path of movement of the base strip.

18. A device according to claim 17 further including cover strip spooling means mounted rearwardly of the plate wherein the forward edge of the plate directs the cover strip rearwardly to the spooling means.

19. A device according to claim 31 wherein the base strip includes a plurality of longitudinally spaced sprocket holes (116) therein and the advancing means includes a sprocket drive (172).

20. A method of applying a carrier tape cover strip (114) to a base strip (112), the cover strip being of the type having a top surface (130) with a longitudinally extending hump (132) projecting upwardly therefrom and sidewalls (120, 122) extending parallel to the hump extending downwardly from the top surface; the method including the step of:

exerting a downward force on the hump as the cover strip is being fed over the base strip whereby to cause the sidewalls to move outwardly to clear the base strip; and thereafter,

removing the downward force from the hump thereby to cause the sidewalls to move inwardly to engage the base strip.

21. A method according to claim 20 including the step of feeding the cover strip along a downwardly tapering ridge whereby to exert the downward force on the hump by engagement with the ridge.

**22.** A method according to claim 21 including the step of guiding the base strip into position below the cover strip.

**23.** A method according to claim 22 including the further step of guiding sidewalls about the base strip as the base strip is guided below the cover strip.

**Revendications**

**1.** Bande porteuse comportant :

un ruban allongé (112) de base ;

un ruban allongé (114) de recouvrement formé d'une matière plastique élastique s'étendant sensiblement sur toute la longueur du ruban de base, le ruban de recouvrement ayant une surface supérieure (130) et des parois latérales opposées (120, 122) s'étendant vers le bas depuis la surface supérieure et espacées l'une de l'autre d'une distance sensiblement égale à la largeur du ruban de base et coopérant pour fixer le ruban de recouvrement au ruban de base, et un bossage (132) s'étendant longitudinalement, parallèlement aux parois latérales, faisant saillie vers le haut à partir de la surface supérieure, de manière que, lorsque l'on appuie sur le bossage, les parois latérales se déplacent vers l'extérieur, s'écartant l'une de l'autre pour libérer le ruban de recouvrement du ruban de base.

**2.** Bande porteuse selon la revendication 1, dans laquelle chaque paroi latérale se termine par un bec (124, 126) dirigé vers l'intérieur faisant saillie au-dessous du ruban de base, les becs s'étendant sur une distance telle que, lorsque le bossage est enfoncé, ils se déplacent vers l'extérieur pour libérer le ruban de base.

**3.** Bande porteuse selon la revendication 1, dans laquelle le ruban de base ou le ruban de recouvrement présente plusieurs cavités (116) pour composants, espacées longitudinalement, s'étendant vers le bas.

**4.** Bande porteuse selon la revendication 1, dans laquelle le ruban de base présente plusieurs perforations d'entraînement (118) espacées longitudinalement.

**5.** Bande porteuse selon la revendication 4, dans laquelle les perforations d'entraînement (118) sont alignées avec le bossage du ruban de recouvrement.

**6.** Bande porteuse selon la revendication 1, dans laquelle le ruban de base présente plusieurs perforations d'entraînement (118) espacées longitudinalement, adjacentes aux cavités (116).

**7.** Bande porteuse selon la revendication 6, dans laquelle les perforations d'entraînement (118) sont alignées avec le bossage du ruban de recouvrement.

**8.** Dispositif pour appliquer un ruban (114) de recouvrement d'une bande porteuse à un ruban de base (112), le ruban de recouvrement étant du type présentant une surface supérieure (130) ayant un bossage (132) s'étendant longitudinalement qui en fait saillie vers le haut, et des parois latérales (120, 122) s'étendant parallèlement au bossage et vers le bas à partir de la surface supérieure ; le dispositif comportant :

un guide (142) destiné à recevoir le ruban de base ; et

un élément profilé (144) d'alimentation s'étendant au-dessus du guide pour recevoir le ruban de recouvrement et amener le ruban de recouvrement dans une position au-dessus du ruban de base, l'élément profilé d'amenée présentant une face intérieure (162) profilée de façon à recevoir le ruban de recouvrement et présentant une crête (164) destinée à recevoir le bossage et un moyen (166) destiné à exercer une force vers le bas sur le bossage pendant que la feuille de recouvrement passe dans le profilé.

**9.** Dispositif selon la revendication 8, dans lequel la crête (164) s'effile vers le bas dans la direction du déplacement du ruban de recouvrement de façon à exercer la force vers le bas sur le ruban de recouvrement.

**10.** Dispositif selon la revendication 8, dans lequel le moyen exerçant une force comprend une tige passant à travers la crête (164) afin que la force exercée vers le bas sur le ruban de recouvrement puisse être modifiée par réglage de la portée de la vis.

**11.** Dispositif selon la revendication 9, dans lequel le moyen exerçant une force comprend une vis (166) s'étendant à travers la crête (164) de façon que la force exercée vers le bas sur le ruban de recouvrement puisse être modifiée par réglage de la portée de la vis.

**12.** Dispositif selon la revendication 8 ou la revendication 9, dans lequel le ruban de base de la bande porteuse présente plusieurs cavités (116) à composants espacées longitudinalement et le guide comprend une partie centrale rainurée (146) destinée à recevoir les cavités.

13. Dispositif selon l'une quelconque des revendications 8, 9 et 10, dans lequel le guide présente une face supérieure destinée à supporter le ruban de base et le guide comporte en outre deux parois latérales opposées (154, 156) espacées vers l'extérieur de la face supérieure, chacune des parois latérales comprenant une partie supérieure (158, 160) inclinée vers le haut en direction de l'autre paroi latérale.

14. Dispositif selon la revendication 9, dans lequel le guide présente une face supérieure destinée à supporter le ruban de base et le guide comporte en outre deux parois latérales opposées, espacées vers l'extérieur de la face supérieure, chacune desdites parois latérales comprenant une partie supérieure inclinée vers le haut en direction de l'autre paroi latérale.

15. Dispositif pour séparer un ruban de recouvrement (114) de bande porteuse de son ruban de base (112), le ruban de recouvrement étant du type présentant une surface supérieure (130) ayant un bossage (132) s'étendant longitudinalement, qui en fait saillie vers le haut, et les parois latérales (120, 122) s'étendant parallèlement au bossage et vers le bas à partir de la surface supérieure et autour du ruban de base, le dispositif comportant : un moyen (172) destiné à faire avancer la bande porteuse, un moyen (180) destiné à appliquer une force vers le bas sur le bossage pendant que la bande avance afin de séparer le ruban de recouvrement du ruban de base, et un moyen destiné à diriger le ruban de recouvrement en dehors du trajet du mouvement du ruban de base.

16. Dispositif selon la revendication 15, dans lequel le moyen de direction comprend une plaque (176) ayant une gorge (175) destinée à emprisonner le bossage (132) et une tige (180) s'étendant à travers la gorge pour porter contre le bossage et lui appliquer une force.

17. Dispositif selon la revendication 16, comprenant en outre un moyen destiné à faire avancer la bande vers l'avant et dans lequel la plaque comporte un bord de came avant dirigeant le ruban de recouvrement vers l'arrière à l'écart du trajet du mouvement du ruban de base.

18. Dispositif selon la revendication 17, comprenant en outre un moyen de bobinage du ruban de recouvrement monté en arrière de la plaque, le bord avant de la plaque dirigeant le ruban de recouvrement vers l'arrière en direction du moyen de bobinage.

19. Dispositif selon la revendication 15, dans lequel le ruban de base présente plusieurs trous d'entraînement (116) espacés longitudinalement et le moyen d'avance comprend une transmission à roue dentée (172).

20. Procédé d'application d'un ruban de recouvrement (114) d'une bande porteuse sur un ruban de base (112), le ruban de recouvrement étant du type présentant une surface supérieure (130) ayant un bossage (132) s'étendant longitudinalement, qui en fait saillie vers le haut et des parois latérales (120, 122) s'étendant parallèlement au bossage et vers le bas depuis la surface supérieure ; le procédé comprenant les étapes qui consistent :
à exercer une force vers le bas sur le bossage pendant que le ruban de recouvrement est amené au-dessus du ruban de base afin d'amener les parois latérales à se déplacer vers l'extérieur pour se dégager du ruban de base ; et ensuite,
à supprimer la force exercée vers le bas sur le bossage afin d'amener les parois latérales à se déplacer vers l'intérieur pour s'enclencher avec le ruban de base.

21. Procédé selon la revendication 20, comprenant l'étape qui consiste à faire avancer le ruban de recouvrement le long d'une arête s'effilant vers le bas afin d'exercer la force vers le bas sur le bossage par engagement avec l'arête.

22. Procédé selon la revendication 21, comprenant l'étape qui consiste à guider le ruban de base jusqu'en position au-dessous du ruban de recouvrement.

23. Procédé selon la revendication 22, comprenant en outre l'étape qui consiste à guider les parois latérales autour du ruban de base pendant que le ruban de base est guidé au-dessous du ruban de recouvrement.

**Patentansprüche**

1. Trägerband mit:
einem länglichen Grundstreifen (112);
einem länglichen Abdeckstreifen (114), der aus einem federnden Kunststoffmaterial geformt ist und im wesentlichen die gleiche Längserstrekkung wie der Grundstreifen aufweist, wobei der Abdeckstreifen eine obere Fläche (130) und gegenüberliegende Seitenwände (120, 122) hat, die sich von der oberen Fläche nach unten erstrecken, voneinander mit einem Abstand angeordnet sind, der im wesentlichen der Breite des Grundstreifens entspricht, und die zusammenwirken, um den Abdeckstreifen auf dem Grundstreifen zu sichern, und der Abdeckstreifen ferner eine Erhebung (132) aufweist, die sich parallel zu den Seitenwänden erstreckt und nach oben von der oberen Fläche vorspringt, wobei sich die Seitenwände nach außen und weg voneinander bewegen, wenn die Erhebung niedergedrückt wird, wodurch der Abdeckstreifen von dem Grundstreifen freigesetzt wird.

2. Trägerband nach Anspruch 1, worin jede Seitenwand in einem sich nach innen erstreckenden Haken (124, 126) endet, der unterhalb des Grundstreifens vorsteht, wobei sich die Haken über eine Entfernung so erstrecken, daß sie sich nach außen bewegen, wenn die Erhebung niedergedrückt wird, um den Grundstreifen freizusetzen.

3. Trägerband nach Anspruch 1, worin der Grundstreifen oder der Abdeckstreifen mehrere längs beabstandete, nach unten erstreckende Hohlräume (116) aufweist.

4. Trägerband nach Anspruch 1, worin der Grundstreifen mehrere längs beabstandete, sich in den Streifen erstreckende Führungslöcher (118) aufweist.

5. Trägerband nach Anspruch 4, worin die Führungslöcher (118) mit der Erhebung des Abdeckstreifens ausgerichtet sind.

6. Trägerband nach Anspruch 1, worin der Grundstreifen mehrere längs beabstandete Führungslöcher (118) aufweist, die sich in dem Streifen benachbart zu den Hohlräumen (116) erstrecken.

7. Trägerband nach Anspruch 6, worin die Führungslöcher (118) mit der Erhebung des Abdeckstreifens ausgerichtet sind.

8. Vorrichtung zur Anwendung eines Abdeckstreifens (114) eines Trägerbandes auf einen Grundstreifen (112), wobei der Abdeckstreifen von dem Typ ist, der eine obere Fläche (130) mit einer sich längserstreckenden, nach oben vorspringenden Erhebung (132) aufweist sowie Seitenwände (120, 122), die sich parallel zu der Erhebung und nach unten von der oberen Fläche weg erstrecken, wobei die Vorrichtung

eine Führung (142) zur Aufnahme des Grundstreifens, und ein Führungkanalteil (144) aufweist, das die Führung überlagert zur Aufnahme des Abdeckstreifens und den Abdeckstreifen in eine Position über dem Grundstreifen führt, wobei das Führungskanalteil eine innere Fläche (162), die den Abdeckstreifen aufnimmt und einen Grat (164) zur Aufnahme der Erhebung hat, und ein Mittel (166) aufweist zur Ausübung einer nach unten gerichteten Kraft auf die Erhebung, wenn der Abdeckstreifen den Kanal passiert.

9. Vorrichtung nach Anspruch 8, worin der Grat (164) sich nach unten in der Richtung der Bewegung des Abdeckstreifens verjüngt, wobei eine nach unten gerichtete Kraft auf den Abdeckstreifen ausgeübt wird.

10. Vorrichtung nach Anspruch 8, worin das die Kraft ausübende Mittel einen Stab aufweist, der sich durch den Grat (164) erstreckt, wodurch die auf den Abdeckstreifen ausgeübte, nach unten gerichtete Kraft durch Einstellung der Ausdehnung einer Schraube variiert werden kann.

11. Vorrichtung nach Anspruch 9, worin das die Kraft ausübende Mittel eine Schraube (166) aufweist, die sich durch den Grat (164) erstreckt, wodurch die auf den Abdeckstreifen ausgeübte, nach unten gerichtete Kraft durch Einstellung der Ausdehnung der Schraube verändert werden kann.

12. Vorrichtung nach Anspruch 8 oder Anspruch 9, worin der Grundstreifen des Trägerbandes mehrere, längs beabstandete Hohlräume (116) aufweist, und die Führung einen mittleren Nutenabschnitt (146) zur Aufnahme der Hohlräume hat.

13. Vorrichtung nach einem der Ansprüche 8, 9 und 10, worin die Führung eine obere Fläche für die Lagerung des Grundstreifens hat sowie ferner ein Paar von gegenüberliegenden Seitenwänden (154, 156) hat, die nach außen von der oberen Fläche beabstandet sind und jeweils einen oberen Abschnitt (158, 160) aufweisen, welche sich nach unten zu der anderen Seitenwand verjüngen.

14. Vorrichtung nach Anspruch 9, worin die Führung eine obere Fläche für die Lagerung des Grundstreifens aufweist sowie ferner ein Paar von gegenüberliegenden Seitenwänden, die nach außen von der oberen Fläche beabstandet sind und jeweils einen oberen Abschnitt aufweisen, welcher sich nach unten zu der anderen Seitenwand erstreckt.

15. Vorrichtung zur Trennung eines Abdeckstreifens (114) eines Tägerbandes von einem Grundstreifens (112), wobei der Abdeckstreifen von dem Typ ist, der eine obere Fläche (130) mit einer sich längs erstreckenden, nach oben vorspringenden Erhebung (132) aufweist sowie Seitenwände (120, 122), die sich parallel zu der Erhebung und nach unten von der oberen Fläche weg sowie um den Grundstreifen erstrecken, wobei die Vorrichtung ein Mittel (172) zum Transport des Trägerbandes aufweist, ein Mittel (180) zur Anwendung einer nach unten gerichteten Kraft auf die Erhebung, wenn das Band vorrückt, wodurch der Abdeckstreifen von dem Grundstreifen getrennt wird, und ein Mittel zum Führen des Abdeckstreifens auf dem Bewegungspfad des Grundstreifens heraus.

16. Vorrichtung nach Anspruch 15, worin das Führungsmittel eine Platte (176) mit einer Nut (175) zum Erfassen der Erhebung (132) aufweist sowie einen Stab (180), der sich durch die Nut erstreckt, um mit der Erhebung in Eingriff zu treten und eine Kraft darauf auszuüben.

17. Vorrichtung nach Anspruch 16, die ferner ein Mittel zum Vorwärtsrücken des Bandes aufweist, und worin die Platte eine vordere Nokkenkante hat, die den Abdeckstreifen nach hinten von dem Bewegungspfad des Grundstreifens weg führt.

18. Vorrichtung nach Anspruch 17, die ferner ein hinter der Platte befestigtes Aufspulmittel für den Abdeckstreifen aufweist, und worin die vordere Kante der Platte den Abdeckstreifen nach hinten zu dem Aufspulmittel führt.

19. Vorrichtung nach Anspruch 15, worin der Grundstreifen mehrere, längs beabstandete Führungslöcher (116) aufweist, und das Transportmittel einen Transportantrieb (172) hat.

20. Verfahren zur Anwendung eines Abdeckstreifens (114) eines Trägerbandes auf einen Grundstreifen (112), wobei der Abdeckstreifen von dem Typ ist, der eine obere Fläche (130) mit einer sich längs erstreckenden, nach oben vorspringenden Erhebung (132) aufweist sowie Seitenwände (120, 122), die sich parallel zu der Erhebung und nach unten von der oberen Fläche weg erstrecken, wobei das Verfahren den folgenden Schritt aufweist:

Ausübung einer nach unten gerichteten Kraft auf die Erhebung, wenn der Abdeckstreifen über den Grundstreifen geführt wird, wodurch die Seitenwände sich nach außen bewegen, um den Grundstreifen aufzunehmen, und anschließend
die nach unten gerichtete Kraft von der Erhebung entfernt wird, so daß die Seitenwände sich nach innen bewegen, um mit dem Grundstreifen in Eingriff zu treten.

21. Verfahren nach Anspruch 20, daß den Schritt des Transports des Abdeckstreifens entlang eines sich nach unten verjüngenden Grates aufweist, wodurch eine nach unten gerichtete Kraft auf die Erhebung durch Eingriff mit dem Grat ausgeübt wird.

22. Verfahren nach Anspruch 21, daß den Schritt des Führens des Grundstreifens in eine Position unterhalb des Abdeckstreifens aufweist.

23. Verfahren nach Anspruch 22, daß den weiteren Schritt des Führens der Seitenwände um den Grundstreifen aufweist, wenn der Grundstreifen unter den Abdeckstreifen geführt ist.

FIG.1

FIG.3

FIG.2

FIG.4

FIG.5

FIG.6

FIG.7

FIG.8

FIG.9

FIG.9A

FIG.10

EP 0 276 539 B1

FIG.11

FIG.12

FIG.13

FIG.14

FIG. 15

FIG. 16.

17

FIG.17

FIG.18

FIG.19

FIG.20

FIG.21

FIG.22

FIG.23